# EUROPÄISCHE PATENTSCHRIFT

(11) **EP 2 886 510 B1**
(45) Veröffentlichungstag und Bekanntmachung des Hinweises auf die Patenterteilung: **17.10.2018**
(21) Anmeldenummer: 14195314.1
(22) Anmeldetag: 28.11.2014
(51) Int. Cl.: B81B 7/00

(54) **Verfahren zum Herstellen eines elektronischen Bauteils, bei dem ein Sensor-Element von dem Grundmaterial schwingungs- und thermomechanisch entkoppelt ist, sowie elektronisches Bauteil**
Method of forming an electronic component, in which a sensing element is decoupled from the base material in a vibration and thermo-mechanical sense, and electronic component
Procédé de fabrication d'un composant électronique, selon lequel un élément de capteur est découplé de manière thermomécanique et articulée du matériau de base et composant électronique

(30) Priorität: 19.12.2013 DE 102013226686
(43) Veröffentlichungstag der Anmeldung: 24.06.2015
(73) Patentinhaber: ROBERT BOSCH GMBH, 70442 Stuttgart (DE)
(72) Erfinder: Ehrenpfordt, Ricardo, 70825 Korntal-Muenchingen (DE); Ante, Frederik, 70197 Stuttgart (DE); Kenntner, Johannes, 70825 Korntal-Muenchingen (DE)

(56) Entgegenhaltungen:
- DE-A1-102010 001 711
- US-A1- 2006 220 045
- US-A1- 2013 049 232

## Beschreibung

Die vorliegende Erfindung betrifft ein Verfahren zum Herstellen eines elektronischen Bauteils.

Die US 2013/0049232 A1 offenbart ein Verfahren zum Herstellen eines elektronischen Bauteils mit den Schritten: Bereitstellen eines Grundmaterials, Anordnen einer Opferschicht, welche eine vorbestimmte Dicke aufweist auf das Grundmaterial, Anordnen eines Sensor-Elements oberhalb der Opferschicht, zumindest abschnittsweise seitliches Anbringen eines Dämpfungsmaterials an den Aufbau bestehend auf Opferschicht und Sensor-Element, ausgehend von dem Grundmaterial bis zumindest einer vorbestimmten Höhe des Sensor-Elements und entfernen der Opferschicht, wodurch das Sensor-element nach dem Entfernen der Opferschicht von dem Grundmaterial getrennt ist, und das Sensor-Element mit Hilfe des Dämpfungsmaterials eine vibrations- und thermomechanische Kopplung von dem Grundmaterial aufweist.

In DE 10 2010 001 711 A1 ist ein Verfahren zur Herstellung eines Halbleiter-Bauelements beschrieben, wobei eine Opferschicht aus einem thermisch zersetzbaren Polymer verwendet wird.

### Stand der Technik

Hochauflösende aktuelle Inertialsensoren, welche aus einem Beschleunigungs- und Drehratensensor sowie einer zugehörigen Auswertelektronik bestehen, werden in zunehmendem Maße an Stellen mit einer hohen Vibrationsbelastung (zum Beispiel bei Anwendungen im Automobilbereich) eingesetzt. Diese Vibrationen können zu signifikanten Fehlsignalen der Sensoren führen.

Speziell bei modernen LGA/BGA-Gehäusen zeigt sich die Wichtigkeit einer wirksamen Entkopplung der Leiterplatte vom Sensor, da die Gehäuse über keine Leads verfügen, welche bei beispielsweise SOIC Gehäusen noch für eine gewisse Vibrationsentkopplung sorgen können.

Neben diesen Vibrationsbelastungen von ESP-Sensoren werden aber auch zunehmend Sensoren für Anwendungen in der Unterhaltungselektronik aufgrund ihrer zunehmenden Miniaturisierung durch Stresseinflüsse beeinflusst. Im Speziellen gilt dies für die PorSi-Membranen von Drucksensoren und MEMS-Mikrofonen, welche durch den thermomechanischen Stress des Substrates beim Löten oder bei einem Temperaturwechsel signifikant beeinflusst werden können. Aktuelle Konzepte verwenden eine weiche, mehrere Zehntel Mikrometer dicke Silikonklebersicht unter dem MEMS Bauelement, um so den thermomechanischen Stress zu entkoppeln. Da die MEMS Bauelemente über Drahtbonden kontaktiert werden, muss eine gewisse Festigkeit des Bauelements beim Bonden sichergestellt werden. Deshalb kann diese Silikonkleberschicht nicht beliebig dick bzw. ein beliebig weicher Kleber verwendet werden.

So offenbart DE 10 2006 002 350 A1 eine Anordnung eines Inertialsensors zur Montage in einem Kraftfahrzeug mit einem auf einem Träger angebrachten Sensormodul, das einen mikromechanisch hergestellten Inertialsensor und eine Auswerteschaltung umfasst. Es ist vorgesehen, dass das Sensormodul durch ein elastisches Koppelelement mit dem Träger verbunden ist, so dass das First-Level-Modul auf einen mechanischen Dämpfer integriert wird.

Ein anderer Ansatz ist aus der DE 10 2006 026 878 A1 bekannt, wobei ein Premold-Gehäuse zur Aufnahme einer Chipstruktur, in dem ein Teil des Gehäuses, der mit der Chipstruktur verbunden ist, elastisch auslenkbar mit einem weiteren Teil des Gehäuses, der an einer das gesamte Gehäuse tragenden Stützstruktur befestigt wird, verbunden ist, wobei sich beide Gehäuseteile nicht berühren.

### Vorteile der Erfindung

Die in den unabhängigen Patentansprüchen 1 und 5 definierten Verfahren zum Herstellen eines elektronischen Bauteils weisen den Vorteil auf, dass nunmehr bei einem elektronischen Bauteil eine kompakte Struktur für eine vibrations- und thermomechanische Entkopplung von einzelnen elektronischen Bauelementen realisiert werden kann, wodurch sich ein großes Potential zur Kostenersparnis ergibt. So können bei dem vorliegenden elektronischen Bauteil gezielt zum Beispiel nur die MEMS-Sensoren gedämpft werden, welche tatsächlich durch Vibrationen gestört werden, während andere Sensoren des elektronischen Bauteils je nach Verwendungsumgebung auf herkömmliche Weise mit dem Grundmaterial des elektronischen Bauteils verbunden sind. Diese beiden gegensätzlichen Randbedingungen können mit Hilfe der vorliegenden Verfahren nunmehr innerhalb eines einzigen elektronischen Bauteils realisiert werden.

Im Rahmen der vorliegenden Erfindung soll unter einem Sensor-Element ein beliebiges Bauteil verstanden werden, welches die Funktion eines Sensors erfüllt. Insbesondere kann das Sensor-Element als ein MEMS-Element oder als ein beliebiger weiterer mikroelektrischer Sensor bzw. eine mikroelektrische Struktur ausgebildet sein, und es können zudem beliebige Bauteile oder Elemente, welche im Kontext eines elektronischen Bauteils Verwendung finden, vibrations- und thermomechanisch von dem Grundmaterial entkoppelt werden.

Der Kern der vorliegenden Erfindung ist es, ein Sensor-Element durch geeignete Techniken so auf einem Grundmaterial des elektronischen Bauteils zu integrieren, dass die Unterseite des Sensor-Elements nicht oder nur teilweise über ein Verbindungsmaterial bzw. ein Dämpfungsmaterial mit dem Grundmaterial in Verbindung steht. Das Sensor-Element kann auch nur an dessen Seitenwänden und/oder von seiner Oberseite oder seiner Unterseite aus auf dem Grundmaterial fixiert werden. Vorzugsweise ist das Dämpfungsmaterial oder das Verbindungsmaterial ein weicher Kleber oder ein Silikon.

Hierzu wird zunächst eine Opferschicht auf das Sensor-Element vor dem Bestücken aufgebracht. Die Opferschicht kann ein Polymer sein. Das bedeutet, dass die Unterseite des Sensor-Elements im vorliegenden Prozess über die Opferschicht zunächst fest mit dem Grundmaterial verbunden ist. Diese mechanische Verbindung wird erst später durch einen geeigneten Prozessschritt gelöst, durch einen Temperaturschritt, bei welchem die Opferschicht entfernt wird, so dass das Sensor-Element dann nur noch partiell mit dem Grundmaterial verbunden ist.

Alternativ kann die Opferschicht auch auf das Grundmaterial aufgebracht werden. In diesem Fall bringt das Sensor-Element die Opferschicht nicht mit.

Eine elektrische Verbindung zwischen dem Sensor-Element und dem Grundmaterial oder weiteren Sensoren wird bei dem vorliegenden Verfahren vorzugsweise durch Drahtbonds realisiert.

Das Dämpfungsmaterial bzw. das Verbindungsmaterial sorgt für eine vibrations- und thermomechanische Entkopplung zwischen dem Sensor-Element und dem Grundmaterial, welches wiederum beispielsweise mittels Löten starr an ein Substrat (beispielsweise an eine Kundenleiterplatte) gefügt werden kann.

Das Grundmaterial ist generell beliebig wählbar. Es kann auf beiden Seiten Metallisierungen in Form von Leiterbahnen enthalten, welche mittels elektrischen Vias durch das Grundmaterial miteinander verbunden sind. Die Metallisierungen auf der Oberfläche können durch Bonden mit dem Sensor-Element und weiteren elektronischen Schaltungen für das elektronische Bauteil, wie zum Beispiel von ASIC(s), verbunden werden. Die Metallflächen auf der Unterseite werden mittels Löten oder einem Leitkleber mit einem weiteren Substrat starr gefügt. Alternativ dazu kann auch ein Leadframe als Grundmaterial verwendet werden.

Gemäß der Erfindung ist die Opferschicht ein thermisch zersetzbarer Werkstoff, und der Schritt des Entfernens der Opferschicht erfolgt mittels thermischen Zersetzens. Insbesondere kann der thermisch zersetzbare Werkstoff ein thermisch zersetzbares Polymer, insbesondere ein thermisch zersetzbares Polyimid sein, welches zum Beispiel auf der Wafer-Ebene vollflächig bzw. großflächig aufgebracht wird und gegebenenfalls nachträglich durch Lasern oder Ätzen gezielt strukturiert wird. Alternativ dazu kann die Opferschicht auch durch Siebdruck auf den Wafer oder direkt auf das Grundmaterial aufgebracht werden.

Die Opferschicht verbindet das Sensor-Element während des gesamten vorliegenden Verfahrens zur Herstellung des elektronischen Bauteils fest mit dem Grundmaterial. Hierdurch gibt es in vorteilhafter Weise keine Einschränkungen beim Bestücken oder Bonden der elektronischen Bauelemente des elektronischen Bauteils, also hier vorliegend zum Beispiel dem Sensor-Element. Die Zersetzungstemperatur der Opferschicht wird so gewählt, dass diese höher als die notwendige Temperatur für das Bestücken/Bonden ist, so dass eine zuverlässige Prozessfolge gewährleistet wird. Durch die feste Anbindung beim Bestücken/Bonden kann auch ein sehr weicher Kleber (beispielsweise Härte Shore A 10 oder weicher) für das Verbindungsmaterial verwendet werden, auf denen beim Stand der Technik nicht gebondet werden kann.

Bei dem vorliegenden Verfahren kann das Grundmaterial und/oder das Dämpfungsmaterial zumindest eine Öffnung aufweisen, welche zum Ausgasen der Opferschicht beim thermischen Zersetzen vorgesehen ist. So kann sich die Öffnung beispielsweise vollständig durch die Dicke des Grundmaterials erstrecken oder in der Art eines Kanals zu einer Seite des Grundmaterials ausgebildet sein. Für den Fall, dass die Öffnung im Dämpfungsmaterial ausgebildet ist, kann sich diese vorzugsweise zu einer Seite des Dämpfungsmaterials hin in der Art eines Kanals erstrecken.

Gemäß einer weiteren Ausgestaltung des vorliegenden Verfahrens kann das Dämpfungsmaterial ein weicher Kleber oder Silikon sein. Hierdurch können in vorteilhafter Weise durch die Auswahl des Dämpfungsmaterials die Dämpfungseigenschaften des angebundenen Sensor-Elements gezielt eingestellt werden.

Gemäß einer weiteren Ausgestaltung des vorliegenden Verfahrens kann ein Trägerelement oder eine elektronische Schaltung mit dem Sensor-Element starr gekoppelt sein. Das vorliegende Verfahren erlaubt auch die Montage von nicht nur einem Sensor-Element, sondern dieses kann auch zusätzlichen mit einer elektronischen Schaltung, wie zum Beispiel einem ASIC, oder einem Trägerelement, beispielweise in der Art einer Trägerplatte, verbunden sein.

Gemäß einer weiteren Ausgestaltung des vorliegenden Verfahrens kann das Sensor-Element in einer Ausnehmung des Grundmaterials angeordnet sein, wobei das Dämpfungsmaterial zumindest abschnittsweise zwischen der Wandung der Ausnehmung und dem Sensor-Element angeordnet ist. Häufig zeigen Silikone eine relativ geringe Standfestigkeit, das bedeutet die Viskosität ist niedrig und die Fließgrenze hoch. Für solche Materialien kann das Sensor-Element in eine Kavität des Grundmaterials platziert werden, so dass dem Silikon eine Fließgrenze entgegengebracht wird. Daraus ergibt sich zusätzlich in vorteilhafter Weise, dass das Grundmaterial in dem vorliegenden Verfahren nicht planar sein muss, sondern es kann auch eine Kavität aufweisen, sodass auch ein (zunächst) nicht formfestes Dämpfungsmaterial für die Anbindung des Sensor-Elements an das Grundmaterial verwendet werden kann.

Gemäß einer weiteren Ausgestaltung des vorliegenden Verfahrens kann das Verbindungsmaterial ein weicher Kleber oder Silikon sein. Wird das Sensor-Element während des gesamten vorliegenden Verfahrens fest mit dem Grundmaterial verbunden, so kann durch die feste Anbindung beim Bestücken/Bonden kann auch ein sehr weicher Kleber (beispielsweise Härte Shore A 10 oder weicher) für das Verbindungsmaterial verwendet werden, auf denen beim Stand der Technik nicht gebondet werden kann. Die Opferschicht verbindet das Sensor-Element während des gesamten vorliegenden Verfahrens fest mit dem Grundmaterial. Hierdurch gibt es in vorteilhafter Weise keine Einschränkungen beim Bestücken oder Bonden der elektronischen Bauelemente des elektronischen Bauteils, also hier vorliegend zum Beispiel dem Sensor-Element. Die Zersetzungstemperatur der Opferschicht wird so gewählt, dass diese höher als die notwendige Temperatur für das Bestücken/Bonden ist, so dass eine zuverlässige Prozessfolge gewährleistet wird.

Gemäß einer weiteren Ausgestaltung des vorliegenden elektronischen Bauteils können das Verbindungsmaterial oder das Dämpfungsmaterial in Form von beabstandeten Streifen ausgebildet sein. Die Streifen können dabei als Längsstreifen oder als Querstreifen zu dem elektronischen Bauteil oder dem Sensor-Element ausgebildet sein. In einer weiteren Alternative können das Verbindungsmaterial oder das Dämpfungsmaterial unterhalb des Sensor-Elements umlaufend geschlossen angeordnet sein. Des Weiteren können in einer weiteren Alternative das Verbindungsmaterial oder das Dämpfungsmaterial unterhalb des Sensor-Elements umlaufend angeordnet sein, wobei abschnittsweise Ausnehmungen vorgesehen sind, an welchen kein Verbindungsmaterial oder Dämpfungsmaterial vorhanden ist. Weiterhin können das Verbindungsmaterial oder das Dämpfungsmaterial unterhalb des Sensor-Elements punktuell angeordnet sein, wobei die Punkte ein regelmäßiges oder eine unregelmäßiges Muster aufweisen. Schließlich können das Verbindungsmaterial oder das Dämpfungsmaterial in Form von beabstandeten Querstreifen angeordnet sein.

Gemäß einer weiteren Ausgestaltung des vorliegenden elektronischen Bauteils können das Verbindungsmaterial oder das Dämpfungsmaterial zumindest abschnittsweise über die Randbereiche des Sensor-Elements überstehen. Besonders bevorzugt steht dabei das Verbindungsmaterial oder das Dämpfungsmaterial jeweils von dem Sensor-Element im Bereich von dessen Ecken über.

Gemäß einer weiteren Ausgestaltung des vorliegenden elektronischen Bauteils sind das Verbindungsmaterial oder das Dämpfungsmaterial unterhalb des Sensor-Elements angeordnet, und dabei jeweils in Form von Rechtecken, und insbesondere von Quadraten, ausgebildet, welche jeweils in den Eckbereichen des Sensor-Elements angeordnet sind, und die Rechtecke bzw. Quadrate des Verbindungsmaterials oder des Dämpfungsmaterials stehen jeweils von dem Sensor-Element im Bereich von dessen Ecken über.

Gemäß einer weiteren Ausgestaltung des vorliegenden elektronischen Bauelements sind das Verbindungsmaterial oder das Dämpfungsmaterial unterhalb des Sensor-Elements ausgebildet, und dabei jeweils in den Eckbereichen des Sensor-Elements angeordnet. Des Weiteren können die Randbereiche des Verbindungsmaterials oder des Dämpfungsmaterials jeweils bündig mit den Randbereichen des Sensor-Elements abschließen.

### Kurze Beschreibung der Zeichnungen

Die vorliegende Erfindung wird anhand der beiliegenden Zeichnungen erklärt. Es zeigt dabei
Fig. 1: eine Ansicht von der Seite eines elektronischen Bauteils, welches mit einem Verfahren zum Herstellen eines elektronischen Bauteils gemäß der vorliegenden Erfindung hergestellt wurde,
Fig. 2: eine Draufsicht des elektronischen Bauteils gemäß Fig. 1,
Figs. 3 bis 6: eine Ansicht von der Seite von Verfahrensschritten zur Herstellung des elektronischen Bauteils gemäß Fig. 1,
Figs. 7 und 8: eine Ansicht von der Seite von Verfahrensschritten zur Herstellung eines weiteren Ausführungsbeispiels eines elektronischen Bauteils, welches mit einem Verfahren zum Herstellen eines elektronischen Bauteils gemäß der vorliegenden Erfindung hergestellt wurde,
Figs. 9 bis 12: Ansichten weiterer Ausführungsbeispiele für elektronische Bauteile, welche mit einem Verfahren zum Herstellen eines elektronischen Bauteils gemäß der vorliegenden Erfindung hergestellt wurden,
Figs. 13 und 14: Ansichten von der Seite von Verfahrensschritten zur Herstellung eines elektronischen Bauteils gemäß einem weiteren Verfahren zum Herstellen eines elektronischen Bauteils gemäß der vorliegenden Erfindung,
Figs. 15 und 16: Ansichten von der Seite von Verfahrensschritten zur Herstellung eines weiteren elektronischen Bauteils gemäß dem weiteren Verfahren zum Herstellen eines elektronischen Bauteils gemäß der vorliegenden Erfindung, und
Figs. 17 bis 20: verschiedene Ansichten von Öffnungen in einem Verbindungsmaterial zur Verwendung in dem weiteren Verfahren zum Herstellen eines elektronischen Bauteils gemäß der vorliegenden Erfindung.

### Ausführungsformen der Erfindung

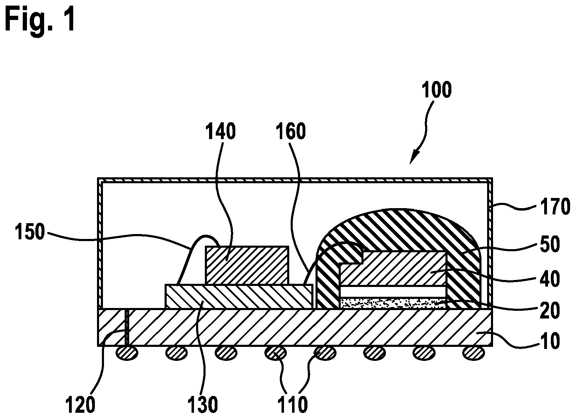

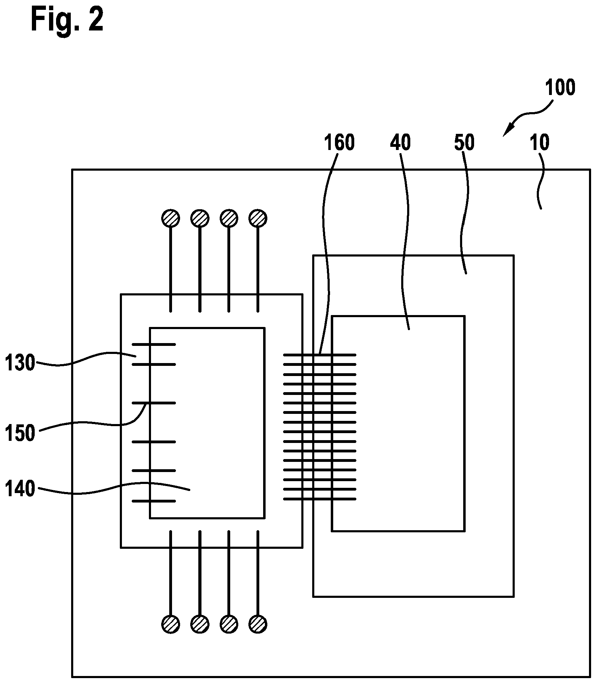

Fig. 1 zeigt eine Ansicht von der Seite eines elektronischen Bauteils 100, welches mit einem Verfahren zum Herstellen eines elektronischen Bauteils gemäß der vorliegenden Erfindung hergestellt wurde, und Fig. 2 zeigt eine Draufsicht des elektronischen Bauteils gemäß Fig. 1.

Das elektronische Bauteil 100 weist ein Grundmaterial 10 auf, welches eine im Wesentlichen quadratische Form aufweist. Auf der Unterseite des Grundmaterials 10 ist eine Vielzahl von Lotkugeln (BGA) 110 angeordnet, welche dem Fachmann wohlbekannt sind. Alternativ dazu können auf der Unterseite des Grundmaterials auch nur Pads (LGA) (nicht dargestellt) angeordnet sein. Auch ein Premold-Gehäuse (nicht dargestellt), wie etwa ein PM28-Gehäuse ist denkbar. Eine Vielzahl von elektrischen Vias 120 durchdringt das Grundmaterial 10 über dessen gesamte Höhe.

Auf der Oberseite des Grundmaterials 10 ist im Bereich von einer Seite eine sogenannte Anwendungsspezifische integrierte Schaltung bzw. ASIC (Application Specific Integrated Circuit) 130 angeordnet, welche je nach Verwendungszweck des elektronischen Bauteils 100 spezielle Aufgaben realisiert. Auf dem ASIC 130 ist ein CMB (Control-Moment-Body) 140 angeordnet, welcher beispielsweise als ein Beschleunigungssensor ausgebildet sein kann. Der CMB 140 und das ASIC 130 sind durch Drahtbonds 150 oder FlipChip Löten (nicht dargestellt) mit dem Grundmaterial 10 verbunden.

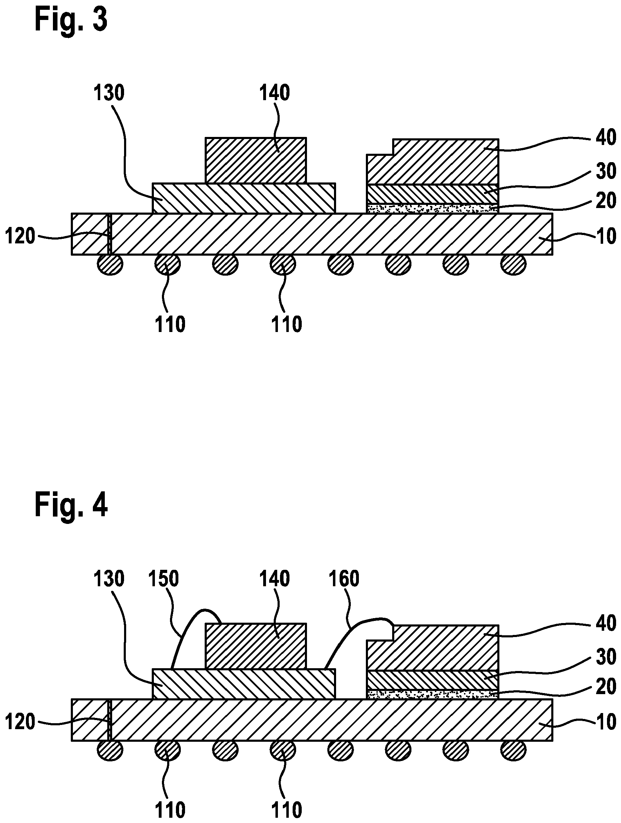

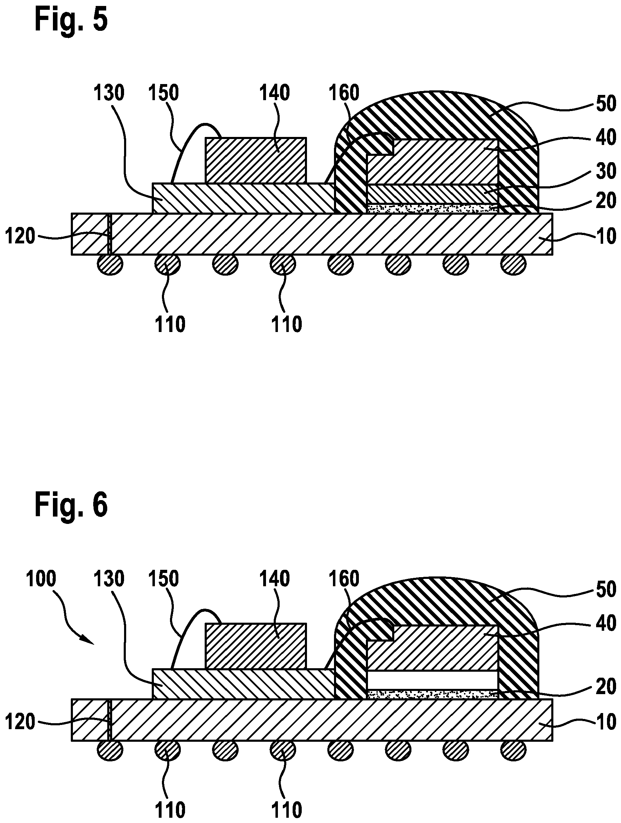

Benachbart und angrenzend zu dem ASIC 130 ist ein MEMS-Element (Micro-Electro-Mechanical System) 40 auf dem Grundmaterial 10 angeordnet, welches über einen weiteren Drahtbond 160 mit dem ASIC 130 verbunden ist. Das MEMS-Element 40 ist über ein Dämpfungsmaterial 50 derart mit dem Grundmaterial 10 gekoppelt, dass es vibrations- und thermomechanisch vom Grundmaterial 10 entkoppelt ist. Dabei wird das MEMS-Element 40 von dem Dämpfungsmaterial 50 gehalten, wobei das MEMS-Element 40 von dem Grundmaterial 10 getrennt ist. Das Dämpfungsmaterial 50 ist Silikon und umgibt das MEMS-Element 40 mit Ausnahme von dessen Unterseite vollständig. Die Herstellung dieser Konfiguration wird unten stehend mit Bezugnahme auf die Figs. 3 bis 6 erörtert werden.

Unterhalb des MEMS-Elements 40 befindet sich noch eine zurückgebliebene Schicht eines Verbindungsmaterials 20, hier insbesondere als eine Kleberschicht realisiert, welche innerhalb des AVT-Prozesses die feste Anbindung des MEMS-Elements 40 an das Grundmaterial 10 vor dem Auftragen des Dämpfungsmaterials 50 sicherstellt. Das Verbindungsmaterial ist aber nicht zwingend notwendig. Ein Deckel 170 schützt die Komponenten des elektronischen Bauteils 100 vor einer Einwirkung von außen.

Bezugnehmend auf Figs. 3 bis 6 sollen nun die Verfahrensschritte zur Herstellung des elektronischen Bauteils 100 gemäß Fig. 1 und Fig. 2 erläutert werden. Die für die Realisierung des vorliegenden Verfahrens zur Herstellung des elektronischen Bauteils 100 nicht relevanten Komponenten werden im Folgenden nicht mehr erörtert werden, sondern finden sich entsprechend in der obigen Ausführung zu der Fig. 1 und Fig. 2. So wird nachfolgend lediglich auf die Anbindung eines Sensor-Elements 40 auf einem Grundmaterial 10 eingegangen werden, welches dabei von selbigem vibrations- und thermomechanisch entkoppelt ist.

Hierbei weist das Verfahren zum Herstellen des elektronischen Bauteils 100, welches insbesondere zur Verwendung als ein Sensor vorgesehen ist, diese Schritte auf. Zunächst wird das Grundmaterial 10 bereitgestellt, welches eine im Wesentlichen quadratische Form aufweist. Die Form des Grundmaterials 10 kann jedoch beliebig sein. Danach erfolgt das zumindest abschnittsweise Aufbringen eines Verbindungsmaterials 20 auf das Grundmaterial 10 mit einer vorgegebenen Dicke. Das Verbindungsmaterial 20 ist vorzugsweise ein harter Klebstoff, welcher eine feste Fixierung von zwei Bauteilen realisieren kann. Danach erfolgt das Anordnen einer Opferschicht 30, welche eine vorbestimmte Dicke aufweist, oberhalb des Verbindungsmaterials 20. Hier ist die Opferschicht 30 ein thermisch zersetzbares Polymer, welches zum Beispiel auf der Wafer-Ebene (nicht dargestellt) vollflächig aufgebracht wird und gegebenenfalls nachträglich durch Lasern oder Ätzen gezielt strukturiert wird. Alternativ dazu kann das thermisch zersetzbare Polymer auch durch Siebdruck auf den Wafer oder direkt auf das Grundmaterial 10 aufgebracht werden.

Anschließend erfolgt der Schritt des Anordnens des MEMS-Elements 40 oberhalb der Opferschicht 30, wobei das Verbindungsmaterial 20 den Aufbau bestehend aus Opferschicht 30 und MEMS-Element 40 auf dem Grundmaterial 10 fixiert. Hier ist auf der Unterseite des MEMS-Elements 40 die Opferschicht fest angeordnet, so dass diese eine bauliche Einheit bilden. Das System aus MEMS-Element 40 und Opferschicht wird, wie vorstehend erwähnt, mit einem Kleber auf dem Grundmaterial 10 fixiert, so dass in einem weiteren Prozessschritt gebondet werden kann. Es ist aber auch möglich, das MEMS-Element 40 mit der Opferschicht 30 direkt auf dem Grundmaterial 10 zu fixieren, so dass diese eine temporäre bauliche Einheit während der Schritte des vorliegenden Verfahrens darstellen. Danach wird zumindest abschnittsweise seitliche Anbringen eines Dämpfungsmaterials 50 an den Aufbau bestehend aus Verbindungsmaterial 20, Opferschicht 30 und MEMS-Element 40 durchgeführt, und zwar ausgehend von dem Grundmaterial 10 bis zumindest einer vorbestimmten Höhe des MEMS-Elements 40 (hier ist das MEMS-Elements 40 mit Ausnahme von dessen Unterseite vollständig von dem Dämpfungsmaterial 50 umgeben). Das Dämpfungsmaterial 50 ist vorzugsweise ein weicher Kleber oder Silikon, welches das MEMS-Element 40 zumindest teilweise oder komplett überzieht.

Schließlich kommt es zum Entfernen der Opferschicht 30, wodurch das MEMS-Element 40 nach dem Entfernen der Opferschicht 30 von dem Grundmaterial 10 getrennt ist, und das MEMS-Element 40 mit Hilfe des Dämpfungsmaterials 50 eine vibrations- und thermomechanische Entkopplung von dem Grundmaterial 10 aufweist. So erfolgt der Schritt des Entfernens der Opferschicht im Kontext des TDP mittels thermischen Zersetzens, wobei die mechanische Verbindung des MEMS-Elements 40 mit dem Grundmaterial 10 aufgelöst wird. Die Zersetzungstemperatur des TDP ist dabei für das Grundmaterial 10, das MEMS-Element 40 (sowie weitere Elektronikkomponenten 130, 140) und das Silikon 50 unkritisch.

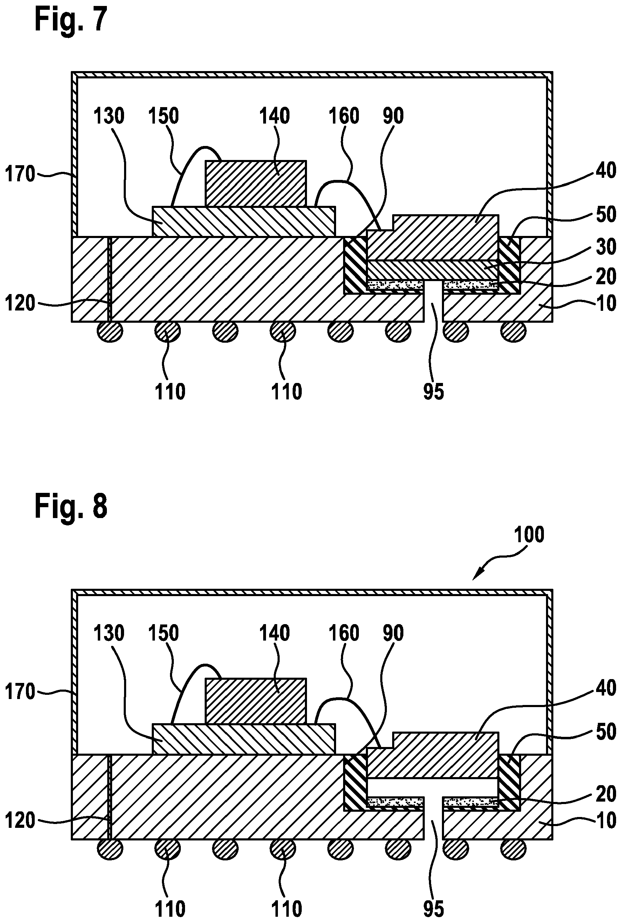

Figs. 7 und 8 zeigen eine Ansicht von der Seite von Verfahrensschritten zur Herstellung eines weiteren Ausführungsbeispiels eines elektronischen Bauteils 100, welches mit einem Verfahren zum Herstellen eines elektronischen Bauteils gemäß der vorliegenden Erfindung hergestellt wurde. Fig. 7 zeigt eine Konfiguration des elektronischen Bauteils 100 vor dem Zersetzen eines thermisch zersetzbaren Werkstoffs TDP 30, während Fig. 8 die Konfiguration des elektronischen Bauteils 100 nach dem Zersetzen des TDP 30 zeigt.

Dabei ist das MEMS-Element 40 in einer Ausnehmung 90 des Grundmaterials 10 angeordnet, wobei das Dämpfungsmaterial 50 zumindest abschnittsweise zwischen der Wandung der Ausnehmung 90 und dem MEMS-Element 40 angeordnet ist. Das Dämpfungsmaterial 50 erstreckt sich dabei von der Unterseite der Ausnehmung 90 bis zur Oberseite des Grundmaterials 10, und weist dabei eine vorbestimmte Dicke auf. Auf diese Weise ist der Randbereich des MEMS-Elements 40 zumindest abschnittsweise mit dem der Wandung der Ausnehmung 90 mittels des Dämpfungsmaterials 50 verbunden.

Einige elastische Materialien zeigen eine relativ geringe Standfestigkeit, das bedeutet die Viskosität ist niedrig und die Fließgrenze hoch. Für solche Materialien kann das MEMS-Element 40 in die Ausnehmung 90 des Grundmaterials 10 platziert werden, so dass dem Silikon eine Fließgrenze entgegengebracht wird. Daraus ergibt sich zusätzlich in vorteilhafter Weise, dass das Grundmaterial 10 in dem vorliegenden Verfahren nicht planar sein muss, sondern es kann auch eine Kavität aufweisen, sodass auch ein (zunächst) nicht formfestes Dämpfungsmaterial für die Anbindung des MEMS-Elements 40 an das Grundmaterial 10 verwendet werden kann. Das MEMS-Element 40 ist zum Teil innerhalb der Ausnehmung 90 angeordnet und ragt mit seinem anderen Teil (dem oberen Teil) von der Oberseite des Grundmaterials 10 hervor. Das MEMS-Element 40 ist in der Ausnehmung 90 angeordnet, sodass das Prozessieren von nicht standfesten weichen Klebern/Silikonen ermöglicht wird.

Außerdem weist das Grundmaterial 10 eine Öffnung 95 auf, welche zum Entfernen der Opferschicht 30 vorgesehen ist. Hier erstreckt sich die Öffnung 95 beispielsweise vollständig durch die Dicke des Grundmaterials 10 bis zu der Ausnehmung 90 hinein. Der Querschnitt der Öffnung 95 kann dabei beliebig gestaltet sein, jedoch vorzugsweise kreisrund, oval oder elliptisch, sowie rechteckig oder quadratisch. Alternativ dazu kann die Öffnung in der Art eines Kanals (nicht dargestellt) zu einer Seite des Grundmaterials ausgebildet sein. Die Öffnung 95 kann generell notwendig werden (nicht nur bei einem Grundmaterial mit Kavitäten), wenn die Zersetzungsprodukte der Opferschicht 30 nicht durch das Dämpfungsmaterial 50 diffundieren können und wenn gleichzeitig keine anderen Entweichungsmöglichkeiten bestehen.

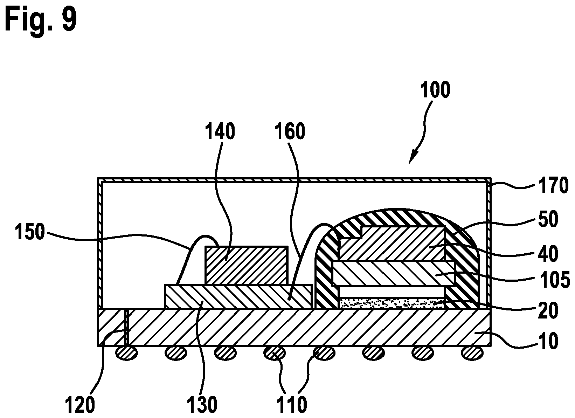

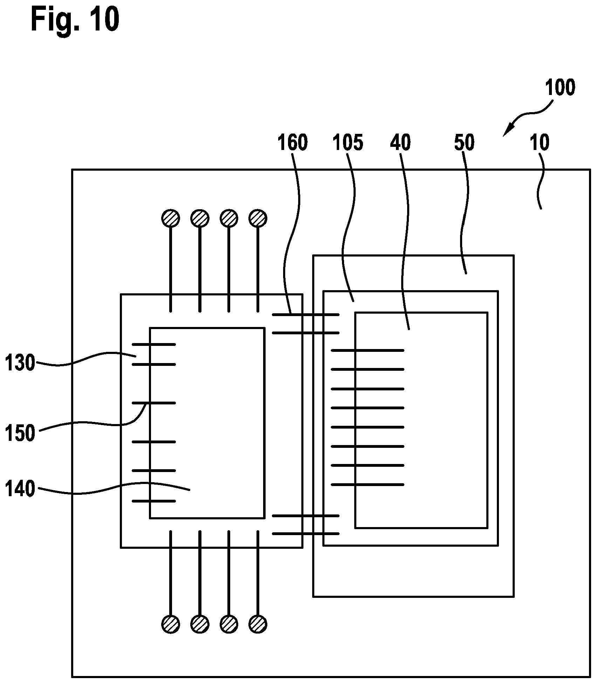

Figs. 9 bis 12 zeigen Ansichten weiterer Ausführungsbeispiele für elektronische Bauteile, welche mit einem Verfahren zum Herstellen eines elektronischen Bauteils 100 gemäß der vorliegenden Erfindung hergestellt wurden. Die Konfiguration des Ausführungsbeispiels für das elektronische Bauteil 100 gemäß Fig. 9 und 10 ist prinzipiell sehr ähnlich zu demjenigen von Fig. 1, weshalb im Folgenden lediglich der Unterschied mit Bezugnahme auf die Figs. 9 und 10 beschrieben werden wird.

Dabei wird ein MEMS-Element 40 von einem Dämpfungsmaterial 50 gehalten, wobei das MEMS-Element 40 von einem Grundmaterial 10 getrennt ist. Das Dämpfungsmaterial 50 ist Silikon und umgibt das MEMS-Element 40 mit Ausnahme von dessen Unterseite vollständig. Des Weiteren ist an der Unterseite des MEMS-Elements 40 eine elektronische Schaltung 105 angeordnet, wobei die elektronische Schaltung 105 starr mit dem MEMS-Element 40 gekoppelt ist. Zwischen der Unterseite der elektronischen Schaltung 105 und einer getrockneten Kleberschicht 20 als eine Ausgestaltung eines Verbindungsmaterials ist ein Hohlraum ausgebildet. Die elektronische Schaltung 105 ist bevorzugt ein ASIC, welcher für die Aufbereitung von Messdaten des MEMS-Elements 40 vorgesehen ist.

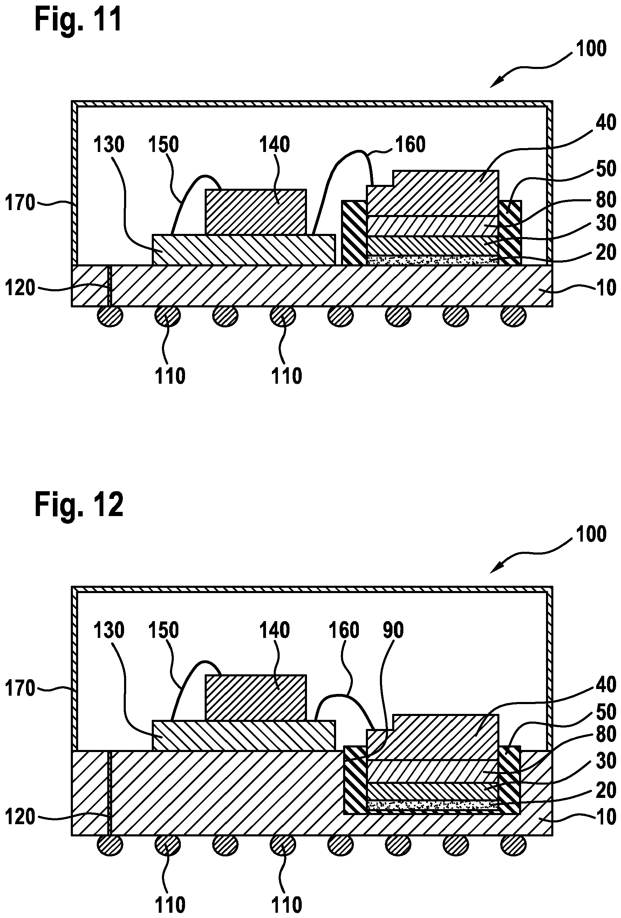

Fig. 11 wiederum zeigt ein weiteres Ausführungsbeispiel eines elektronischen Bauteils 100, welches über ein Trägerelement 80 in Form einer Trägerplatte verfügt, welche unterhalb eines MEMS-Elements 40 angeordnet ist und starr mit diesem verbunden ist. Die Trägerplatte 80 kann beispielsweise als zusätzliche Masse notwendig werden, um so die mechanische Resonanzfrequenz des MEMS-Elements 40 zu beeinflussen. Alternativ zu einer Trägerplatte 80 könnte auch ein Dummy-Siliziumstück (nicht dargestellt) auf das MEMS-Element 40 geklebt werden. Außerdem ist auf der Unterseite der Trägerplatte 80 eine Opferschicht 30 fest angeordnet, so dass diese eine bauliche Einheit bilden. Das System aus MEMS-Element 40, Trägerplatte 80 und Opferschicht 30 kann, wie vorstehend erwähnt, mit einem Verbindungsmaterial in Form eines harten Klebers 20 auf einem Grundmaterial 10 fixiert werden, so dass in einem weiteren Prozessschritt gebondet werden kann. Danach wird ein zumindest abschnittsweises seitliches Anbringen eines Dämpfungsmaterials 50 an den Aufbau bestehend aus Verbindungsmaterial 20, Opferschicht 30, Trägerplatte 80 und MEMS-Element 40 durchgeführt, und zwar ausgehend von dem Grundmaterial 10 bis zumindest einer vorbestimmten Höhe des MEMS-Elements 40. Das Dämpfungsmaterial 50 ist vorzugsweise ein weicher Kleber oder Silikon, welches das MEMS-Element 40 zumindest teilweise oder komplett überzieht. Die Opferschicht 30 wird anschließend, wie vorstehend beschrieben, wieder entfernt.

Fig. 12 zeigt ein weiteres Ausführungsbeispiel eines elektronischen Bauteils 100, welches über ein Trägerelement 80 in Form einer Trägerplatte verfügt, welche unterhalb eines MEMS-Elements 40 angeordnet ist und starr mit diesem verbunden ist. In Unterschied zu dem vorstehend beschriebenen Ausführungsbeispiel ist der Aufbau bestehend aus Verbindungsmaterial 20, Opferschicht 30, Trägerplatte 80 und MEMS-Element 40 in einer Ausnehmung 90 des Grundmaterials 10 angeordnet, wobei die wesentlichen Prinzipien für die Gestaltung der Ausnehmung 90 der Beschreibung des Ausführungsbeispiels des elektronischen Bauteils 100 gemäß Fig. 7 entnommen werden können.

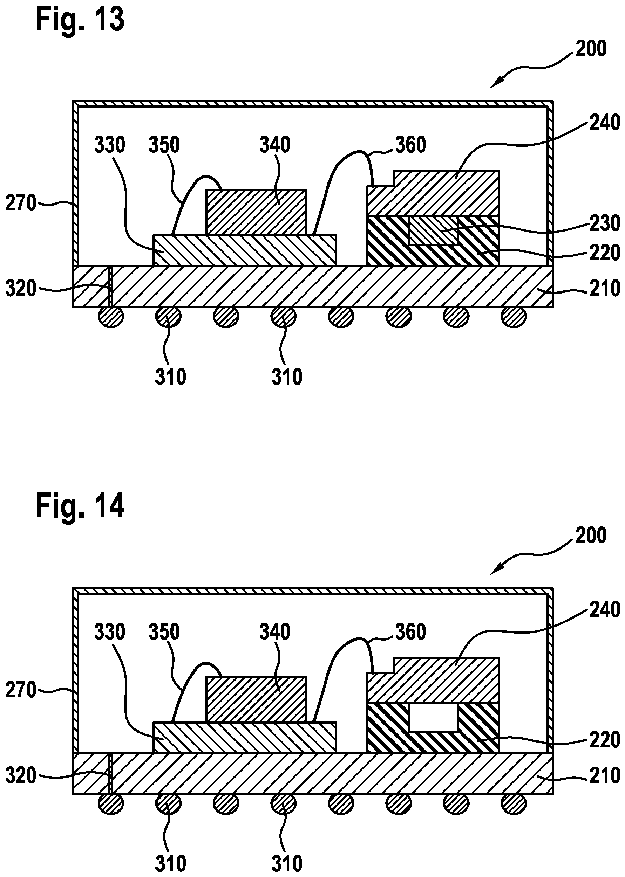

Figs. 13 und 14 zeigen Ansichten von der Seite von Verfahrensschritten zur Herstellung eines elektronischen Bauteils gemäß einem weiteren Verfahren zum Herstellen eines elektronischen Bauteils 200 gemäß der vorliegenden Erfindung.

Das elektronische Bauteil 200 weist ein Grundmaterial 210 auf. Auf der Unterseite des Grundmaterials 210 ist eine Vielzahl von Lotkugeln (BGA) 310 angeordnet, welche dem Fachmann wohlbekannt sind. Alternativ dazu können auf der Unterseite des Grundmaterials auch nur Pads (LGA) (nicht dargestellt) angeordnet sein. Auch ein Premold-Gehäuse (nicht dargestellt), wie etwa ein PM28-Gehäuse ist denkbar. Eine Vielzahl von elektrischen Vias 320 durchdringt das Grundmaterial 210 über dessen gesamte Höhe.

Auf der Oberseite des Grundmaterials 210 ist im Bereich von einer Seite eine sogenannte Anwendungsspezifische integrierte Schaltung bzw. ASIC (Application Specific Integrated Circuit) 330 angeordnet, welche je nach Verwendungszweck des elektronischen Bauteils 200 spezielle Aufgaben realisiert. Auf dem ASIC 330 ist ein weiteres Sensor-Element 340 angeordnet, welches beispielsweise als ein Intertialsensor ausgebildet sein kann. Das Sensor-Element 340 und das ASIC 330 sind durch Drahtbonds 350 oder FlipChip Löten (nicht dargestellt) mit dem Grundmaterial 210 mechanisch und elektrisch verbunden.

Benachbart und angrenzend zu dem ASIC 330 ist ein MEMS-Element (Micro-Electro-Mechanical System) 240 auf dem Grundmaterial 210 angeordnet, welches über einen weiteren Drahtbond 360 mit dem ASIC 330 verbunden ist. Das MEMS-Element 240 ist derart mit einem Verbindungsmaterial 220 gekoppelt, so dass es vibrations- und thermomechanisch vom Grundmaterial 210 entkoppelt ist. Das Verbindungsmaterial 220 ist ein weicher Kleber oder Silikon. Dabei ist das Verbindungsmaterial 220 unter dem MEMS-Element 240 derart geformt, dass sich gerade für die Vibrationsentkopplung bei, zum Beispiel einem MEMS-Element als ein ESP-Sensor, ein geeignetes vibrationsentkoppeltes Verhalten ergibt.

Eine Opferschicht 230 ist innerhalb des Verbindungsmaterials 220 angeordnet, wobei die Opferschicht 230 zwischenliegend zwischen dem Grundmaterial 210 und dem MEMS-Element 240 ist. Die Opferschicht 230 ist ein thermisch zersetzbarer Werkstoff, und der Schritt des Entfernens der Opferschicht 230 erfolgt mittels thermischen Zersetzens. Die Opferschicht 230 ist vor ihrem Entfernen starr mit dem MEMS-Element 240 gekoppelt, so dass es vom MEMS-Element 240 mitgebracht wird.

Ein Deckel 270 schützt die Komponenten des elektronischen Bauteils 200 vor einer Einwirkung von außen. Fig. 14 zeigt das elektronische Bauteil 200 nach dem thermischen Zersetzen der Opferschicht 230, wobei unterhalb des MEMS-Elements 240 ein Hohlraum ausgebildet ist, welcher von dem MEMS-Element 240 und dem Verbindungsmaterial 220 gebildet wird.

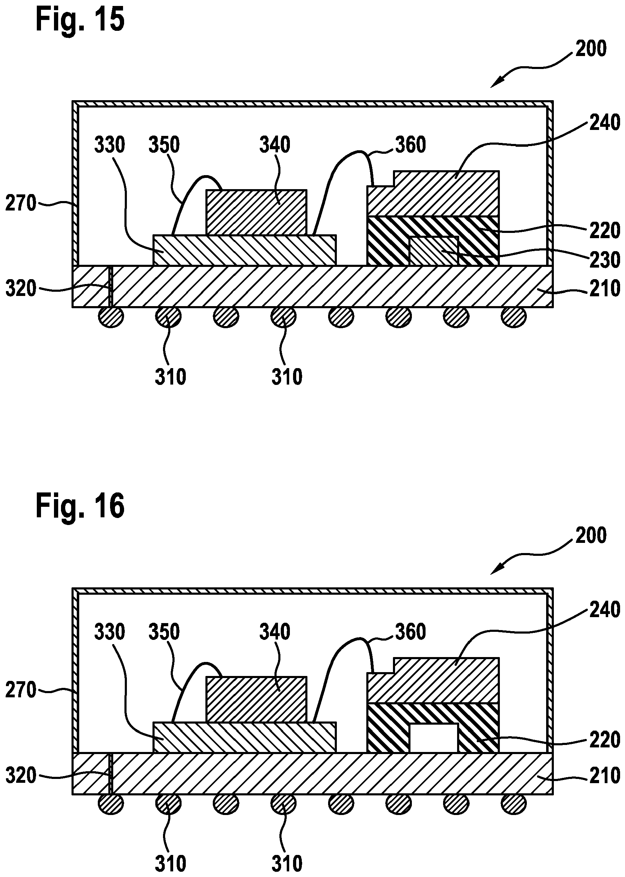

Figs. 15 und 16 zeigen Ansichten von der Seite von Verfahrensschritten zur Herstellung eines weiteren elektronischen Bauteils gemäß dem weiteren Verfahren zum Herstellen eines elektronischen Bauteils 200 gemäß der vorliegenden Erfindung. Die Konfiguration des Ausführungsbeispiels für das elektronische Bauteil 200 gemäß Fig. 15 und 16 ist prinzipiell sehr ähnlich zu demjenigen von Fig. 13, weshalb im Folgenden lediglich der Unterschied mit Bezugnahme auf die Figs. 15 und 16 beschrieben werden wird.

Ein MEMS-Element 240 auf einem Grundmaterial 210 angeordnet. Das MEMS-Element 240 ist derart mit einem Verbindungsmaterial 220 gekoppelt, so dass es vibrations- und thermomechanisch vom Grundmaterial 210 entkoppelt ist. Das Verbindungsmaterial 220 ist ein weicher Kleber oder Silikon. Dabei ist das Verbindungsmaterial 220 unter dem MEMS-Element 240 derart geformt, dass sich gerade für die Vibrationsentkopplung bei, zum Beispiel einem MEMS-Element als ein ESP-Sensor, ein geeignetes vibrationsentkoppeltes Verhalten ergibt. Eine Opferschicht 230 ist innerhalb des Verbindungsmaterials 220 angeordnet, wobei die Opferschicht 230 zwischenliegend zwischen dem Grundmaterial 210 und dem Verbindungsmaterial 220 ist. Die Opferschicht 230 ist ein thermisch zersetzbarer Werkstoff, und der Schritt des Entfernens der Opferschicht 230 erfolgt mittels thermischen Zersetzens. Die Opferschicht 230 wurde vor dem Bestücken des MEMS-Elements 240 auf dem Grundmaterial 210 strukturiert.

Fig. 16 zeigt das elektronische Bauteil 200 nach dem thermischen Zersetzen der Opferschicht 230, wobei unterhalb des Verbindungsmaterials 220 ein Hohlraum ausgebildet ist, welcher von dem Verbindungsmaterial 220 und dem Grundmaterial 210 gebildet wird.

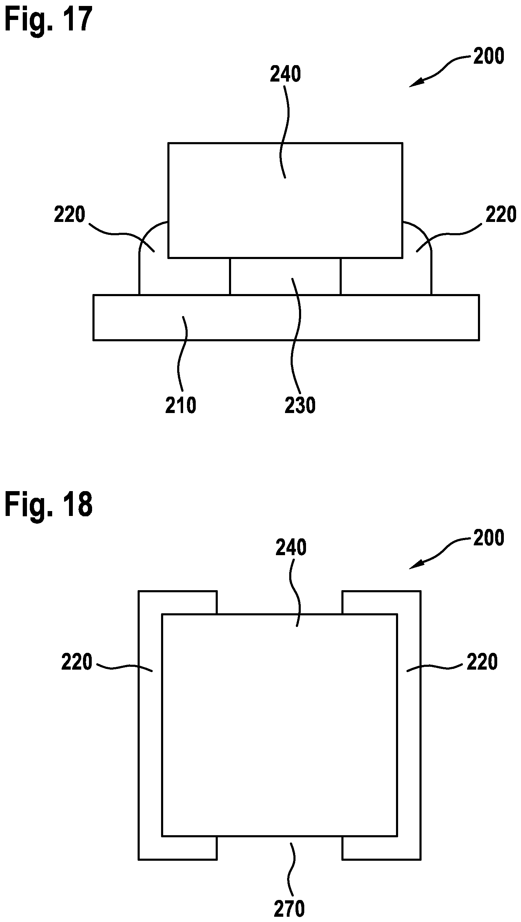

Figs. 17 bis 20 zeigen verschiedene Ansichten von Öffnungen in einem Verbindungsmaterial 220, welche das seitliche Entfernen der Opferschicht zulassen, zur Verwendung in dem weiteren Verfahren zum Herstellen eines elektronischen Bauteils 200 gemäß der vorliegenden Erfindung. Fig. 17 und 18 zeigen in unterschiedlichen Ansichten eine Konfiguration des elektronischen Bauteils 200, bei welchem ein Verbindungsmaterial 220 in Form von Längsstreifen angeordnet ist.

Das elektronische Bauteil 200 weist ein Grundmaterial 210 auf, auf welches das Verbindungsmaterial 220, welches bevorzugt ein weicher Kleber oder Silikon ist, aufgebracht wurde. Das Verbindungsmaterial 220 ist in Form von zwei beabstandeten Längsstreifen ausgebildet. Oberhalb des Verbindungsmaterials 220 ist ein MEMS-Element 240 angeordnet, welches das Verbindungsmaterial 220 teilweise kontaktiert. Unterhalb des MEMS-Elements 240 und zwischen den zwei beabstandeten Längsstreifen des Verbindungsmaterials 220 ist eine Opferschicht 230 innerhalb des Verbindungsmaterials 220 angeordnet, wobei die Opferschicht 230 zwischenliegend zwischen dem Grundmaterial 210 und dem MEMS-Element 240 ist.

Die Opferschicht 230 ist ein thermisch zersetzbarer Werkstoff, und ein Schritt des Entfernens der Opferschicht 230 erfolgt mittels thermischen Zersetzens. Außerdem weist das elektronische Bauteil 200 eine Öffnung 270 auf, welche zum Ausgasen des thermisch zersetzbaren Werkstoffs während dessen thermischen Zersetzens vorgesehen ist. In der Ansicht gemäß Fig. 18 ist die Opferschicht 230 bereits entfernt, und das Grundmaterial 210 ist nicht dargestellt.

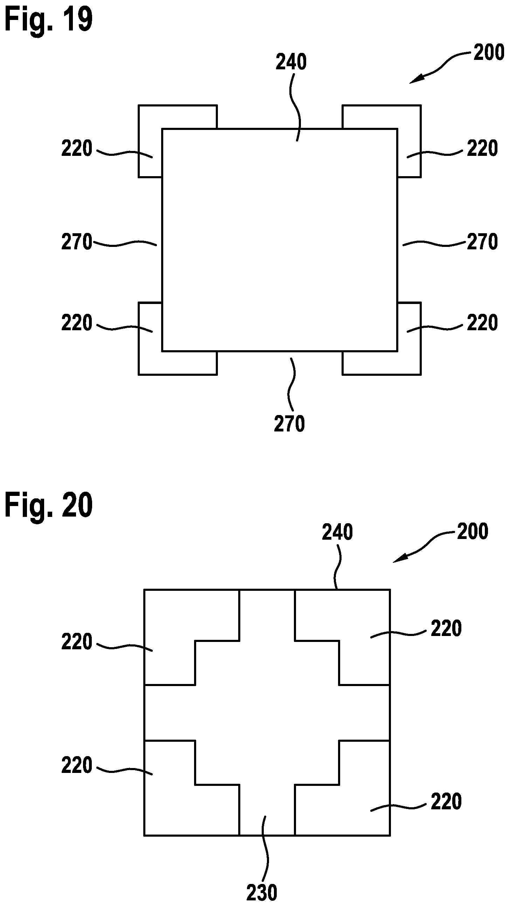

Fig. 19 zeigt in einer Draufsicht eine Konfiguration eines elektronischen Bauteils 200, bei welchem ein Verbindungsmaterial 220 unterhalb eines MEMS-Elements 240 angeordnet ist, und dabei jeweils in Form von Quadraten ausgebildet ist, welche jeweils in den Eckbereichen des MEMS-Elements 240 angeordnet sind. Dabei stehen die Quadrate des Verbindungsmaterials 220 jeweils von dem MEMS-Element 240 im Bereich von dessen Ecken über. In der Ansicht gemäß Fig. 19 ist wiederum eine Opferschicht 230 bereits entfernt, und ein zugehöriges Grundmaterial 210 ist nicht dargestellt.

Fig. 20 zeigt in einer Draufsicht eine Konfiguration eines elektronischen Bauteils 200, bei welchem ein Verbindungsmaterial 220 unterhalb eines MEMS-Elements 240 (hier ist lediglich dessen Berandung dargestellt) angeordnet ist, und dabei jeweils in den Eckbereichen des MEMS-Elements 240 angeordnet ist. Die Randbereiche des Verbindungsmaterials 220 schließen jeweils bündig mit den Randbereichen des MEMS-Elements 240 ab. Außerdem ist eine Opferschicht 230 innerhalb des Verbindungsmaterials 220 angeordnet, wobei die Opferschicht 230 zwischenliegend zwischen dem Grundmaterial 210 und dem MEMS-Element 240 ist. Die Opferschicht 230 ist ein thermisch zersetzbarer Werkstoff, und ein Schritt des Entfernens der Opferschicht 230 erfolgt mittels thermischen Zersetzens.

## Patentansprüche

1. Verfahren zum Herstellen eines elektronischen Bauteils (100), insbesondere zur Verwendung als Sensor, mit den folgenden Schritten:
a) Bereitstellen eines Grundmaterials (10);
b) Anordnen einer Opferschicht (30) aus einem thermisch zersetzbaren Material, welche eine vorbestimmte Dicke aufweist, an einem Sensor-Element (40, 105);
c) zumindest abschnittsweises Aufbringen eines Verbindungsmaterials (20) auf das Grundmaterial (10) mit einer vorgegebenen Dicke, wobei das Verbindungsmaterial (20) den Aufbau bestehend aus Opferschicht (30) und Sensor-Element (40, 105) auf dem Grundmaterial (10) fixiert;
d) zumindest abschnittsweises seitliches Anbringen eines Dämpfungsmaterials (50) an den Aufbau bestehend aus Opferschicht (30) und Sensor-Element (40), ausgehend von dem Grundmaterial (10) bis zumindest einer vorbestimmten Höhe des Sensor-Elements (40); und
e) Entfernen der Opferschicht (30) mittels thermischem Zersetzen, wodurch das Sensor-Element (40, 105) nach dem Entfernen der Opferschicht (30) von dem Grundmaterial (10) getrennt ist, und das Sensor-Element (40) mit Hilfe des Dämpfungsmaterials (50) eine vibrations- und thermomechanische Entkopplung von dem Grundmaterial (10) aufweist.

2. Verfahren nach Anspruch 1, **dadurch gekennzeichnet, dass** das Grundmaterial (10) und/oder das Dämpfungsmaterial (50) zumindest eine Öffnung (70) aufweist, welche zum Entfernen der Opferschicht (30) vorgesehen ist.

3. Verfahren nach einem der vorherigen Ansprüche, **dadurch gekennzeichnet, dass** ein Trägerelement (80) oder eine elektronische Schaltung (105) starr mit dem Sensor-Element (40) gekoppelt ist.

4. Verfahren nach einem der vorherigen Ansprüche, **dadurch gekennzeichnet, dass** das Sensor-Element (40) in einer Ausnehmung (90) des Grundmaterials (10) angeordnet ist, wobei das Dämpfungsmaterial (50) zumindest abschnittsweise zwischen der Wandung der Ausnehmung (90) und dem Sensor-Element (40) angeordnet ist.

5. Verfahren zum Herstellen eines elektronischen Bauteils (200), insbesondere zur Verwendung als Sensor, mit den folgenden Schritten:
a) Bereitstellen eines Grundmaterials (210);
b) zumindest abschnittsweises Aufbringen eines Verbindungsmaterials (220) auf das Grundmaterial (210);
c) Koppeln eines Sensor-Elements (240) mit dem Verbindungsmaterial (220);
und dadurch zumindest abschnittsweises Anordnen einer Opferschicht (230) aus einem thermisch zersetzbaren Material innerhalb des Verbindungsmaterials (220), und zwischenliegend zwischen dem Grundmaterial (210) und dem Sensor-Element (240), wozu die Opferschicht (230) eingangs starr mit dem Sensor-Element (240) gekoppelt oder auf dem Grundmaterial (210) strukturiert wurde; und
d) Entfernen der Opferschicht (230) mittels thermischen Zersetzens, wobei das Verbindungsmaterial (220) derart geformt ist, dass es in seinem Inneren nach dem Entfernen der Opferschicht (230) einen Hohlraum (250) aufweist, und dass das Sensor-Element (240) mit Hilfe des Verbindungsmaterials (220) eine vibrations- und thermomechanische Entkopplung von dem Grundmaterial (210) aufweist.

6. Verfahren nach Anspruch 5, **dadurch gekennzeichnet, dass** das Verbindungsmaterial oder das Dämpfungsmaterial in Form von beabstandeten Streifen (220) ausgebildet wird.

7. Verfahren nach Anspruch 6, **dadurch gekennzeichnet, dass** das Verbindungsmaterial oder das Dämpfungsmaterial zumindest abschnittsweise die Randbereiche des Sensor-Elements übersteht.

8. Verfahren nach Anspruch 5, **dadurch gekennzeichnet, dass** das Verbindungsmaterial oder das Dämpfungsmaterial unterhalb des Sensor-Elements angeordnet wird, und dabei jeweils in Form von Rechtecken ausgebildet ist, welche jeweils in den Eckbereichen des Sensor-Elements angeordnet sind, und die Rechtecke des Verbindungsmaterials oder des Dämpfungsmaterials jeweils von dem Sensor-Element im Bereich von dessen Ecken überstehen.

9. Verfahren nach Anspruch 5, **dadurch gekennzeichnet, dass** das Verbindungsmaterial oder das Dämpfungsmaterial unterhalb des Sensor-Elements ausgebildet wird, und dabei jeweils in den Eckbereichen des Sensor-Elements angeordnet wird.

## Claims

1. Method for producing an electronic component (100), in particular for use as a sensor, comprising the following steps:
a) providing a basic material (10);
b) arranging a sacrificial layer (30) composed of a thermally decomposable material, said sacrificial layer having a predetermined thickness, on a sensor element (40, 105);
c) applying a connection material (20) at least in sections on the basic material (10) with a predefined thickness, wherein the connection material (20) fixes the structure consisting of sacrificial layer (30) and sensor element (40, 105) on the basic material (10);
d) laterally applying a damping material (50) at least in sections to the structure consisting of sacrificial layer (30) and sensor element (40), proceeding from the basic material (10) up to at least a predetermined height of the sensor element (40); and
e) removing the sacrificial layer (30) by means of thermal decomposition, as a result of which the sensor element (40, 105) is separated from the basic material (10) after the sacrificial layer (30) has been removed, and the sensor element (40) has a vibration-and thermo-mechanical decoupling from the basic material (10) with the aid of the damping material (50).

2. Method according to Claim 1, **characterized in that** the basic material (10) and/or the damping material (50) have/has at least one opening (70) provided for removing the sacrificial layer (30).

3. Method according to either of the preceding claims, **characterized in that** a carrier element (80) or an electronic circuit (105) is rigidly coupled to the sensor element (40).

4. Method according to any of the preceding claims, **characterized in that** the sensor element (40) is arranged in a cutout (90) of the basic material (10), wherein the damping material (50) is arranged at least in sections between the wall of the cutout (90) and the sensor element (40) .

5. Method for producing an electronic component (200), in particular for use as a sensor, comprising the following steps:
a) providing a basic material (210);
b) applying a connection material (220) at least in sections on the basic material (210);
c) coupling a sensor element (240) to the connection material (220);
and thereby arranging at least in sections a sacrificial layer (230) composed of a thermally decomposable material within the connection material (220), and in an intervening manner between the basic material (210) and the sensor element (240), for which purpose the sacrificial layer (230) was initially rigidly coupled to the sensor element (240) or structured on the basic material (210); and
d) removing the sacrificial layer (230) by means of thermal decomposition, wherein the connection material (220) is shaped in such a way that it has a cavity (250) in its interior after the sacrificial layer (230) has been removed, and that the sensor element (240) has a vibration- and thermo-mechanical decoupling from the basic material (210) with the aid of the connection material (220).

6. Method according to Claim 5, **characterized in that** the connection material or the damping material is configured in the form of spaced-apart strips (220).

7. Method according to Claim 6, **characterized in that** the connection material or the damping material projects beyond the edge regions of the sensor element at least in sections.

8. Method according to Claim 5, **characterized in that** the connection material or the damping material is arranged below the sensor element, and is configured here in each case in the form of rectangles which are arranged in each case in the corner regions of the sensor element, and the rectangles of the connection material or of the damping material in each case project from the sensor element in the region of the corners thereof.

9. Method according to Claim 5, **characterized in that** the connection material or the damping material is formed below the sensor element, and is arranged here in each case in the corner regions of the sensor element.

## Revendications

1. Procédé de fabrication d'un composant électronique (100), en particulier en vue d'une utilisation comme capteur, comprenant les étapes suivantes:
a) préparer un matériau de base (10);
b) disposer une couche sacrificielle (30) en un matériau décomposable thermiquement, qui présente une épaisseur prédéterminée, sur un élément de capteur (40, 105);
c) déposer au moins localement un matériau de liaison (20) sur le matériau de base (10) avec une épaisseur prédéterminée, dans lequel le matériau de liaison (20) fixe l'ensemble composé de la couche sacrificielle (30) et de l'élément de capteur (40, 105) sur le matériau de base (10);
d) déposer latéralement au moins localement un matériau d'amortissement (50) sur l'ensemble composé de la couche sacrificielle (30) et de l'élément de capteur (40), à partir du matériau de base (10) au moins jusqu'à une hauteur prédéterminée de l'élément de capteur (40); et
e) enlever la couche sacrificielle (30) par décomposition thermique, séparant ainsi l'élément de capteur (40, 105) du matériau de base (10) après l'enlèvement de la couche sacrificielle (30), et l'élément de capteur (40) présente à l'aide du matériau d'amortissement (50) un découplage vibratoire et thermomécanique par rapport au matériau de base (10).

2. Procédé selon la revendication 1, **caractérisé en ce que** le matériau de base (10) et/ou le matériau d'amortissement (50) présente au moins une ouverture (70), qui est prévue pour l'enlèvement de la couche sacrificielle (30).

3. Procédé selon l'une quelconque des revendications précédentes, **caractérisé en ce qu'**un élément de support (80) ou un circuit électronique (105) est couplé de façon rigide à l'élément de capteur (40).

4. Procédé selon l'une quelconque des revendications précédentes, **caractérisé en ce que** l'élément de capteur (40) est disposé dans un évidement (90) du matériau de base (10), dans lequel le matériau d'amortissement (50) est disposé au moins localement entre la paroi de l'évidement (90) et l'élément de capteur (40).

5. Procédé de fabrication d'un composant électronique (200), en particulier en vue d'une utilisation comme capteur, comprenant les étapes suivantes:
a) préparer un matériau de base (210);
b) déposer au moins localement un matériau de liaison (220) sur le matériau de base (210);
c) coupler un élément de capteur (240) au matériau de liaison (220);
et ainsi disposer au moins localement une couche sacrificielle (230) en un matériau décomposable thermiquement à l'intérieur du matériau de liaison (220), et interposé entre le matériau de base (210) et l'élément de capteur (240), ce pourquoi la couche sacrificielle (230) a été initialement couplée de façon rigide à l'élément de capteur (240) ou structurée sur le matériau de base (210); et
d) enlever la couche sacrificielle (230) par décomposition thermique, dans lequel le matériau de liaison (220) est formé de telle manière qu'il présente intérieurement après l'enlèvement de la couche sacrificielle (230) une cavité (250), et que l'élément de capteur (240) présente à l'aide du matériau de liaison (220) un découplage vibratoire et thermomécanique par rapport au matériau de base (210).

6. Procédé selon la revendication 5, **caractérisé en ce que** l'on réalise le matériau de liaison ou le matériau d'amortissement sous la forme de bandes espacées (220).

7. Procédé selon la revendication 6, **caractérisé en ce que** le matériau de liaison ou le matériau d'amortissement déborde au moins localement les zones de bord de l'élément de capteur.

8. Procédé selon la revendication 5, **caractérisé en ce que** le matériau de liaison ou le matériau d'amortissement est disposé en dessous de l'élément de capteur, et est en l'occurrence réalisé respectivement en forme de rectangles, qui sont disposés respectivement dans les régions de coin de l'élément de capteur, et les rectangles du matériau de liaison ou du matériau d'amortissement débordent respectivement de l'élément de capteur dans la région des coins de celui-ci.

9. Procédé selon la revendication 5, **caractérisé en ce que** le matériau de liaison ou le matériau d'amortissement est formé en dessous de l'élément de capteur, et est en l'occurrence disposé respectivement dans les régions de coin de l'élément de capteur.
